(19) **Europäisches Patentamt**
**European Patent Office**
**Office européen des brevets**

(11) **EP 2 500 932 B1**

(12) **EUROPEAN PATENT SPECIFICATION**

(45) Date of publication and mention
of the grant of the patent:
**09.11.2016 Bulletin 2016/45**

(51) Int Cl.:
*C08F 265/04* (2006.01)   *C09J 151/06* (2006.01)
*C09J 151/08* (2006.01)   *C08L 33/06* (2006.01)
*H01L 23/00* (2006.01)   *C08G 59/42* (2006.01)
*C08F 283/10* (2006.01)   *C09J 163/00* (2006.01)
*C08G 59/24* (2006.01)

(21) Application number: **10828148.6**

(22) Date of filing: **09.09.2010**

(86) International application number:
**PCT/JP2010/065474**

(87) International publication number:
**WO 2011/055588 (12.05.2011 Gazette 2011/19)**

(54) **ADHESIVE COMPOSITION**

HAFTZUSAMMENSETZUNG

COMPOSITION D'ADHÉSIF

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority:  **09.11.2009   JP 2009256187**

(43) Date of publication of application:
**19.09.2012   Bulletin 2012/38**

(73) Proprietor: **Dexerials Corporation
Tokyo 141-0032 (JP)**

(72) Inventors:
• **NAMIKI Hidetsugu
Kanuma-shi
Tochigi 322-8503 (JP)**

• **KANISAWA Shiyuki
Kanuma-shi
Tochigi 322-8503 (JP)**
• **KATAYANAGI Genki
Kanuma-shi
Tochigi 322-8503 (JP)**

(74) Representative: **Müller-Boré & Partner
Patentanwälte PartG mbB
Friedenheimer Brücke 21
80639 München (DE)**

(56) References cited:
**WO-A1-2009/044732     JP-A- 2002 146 324
JP-A- 2008 063 551**

**Description**

Technical Field

The present invention relates to an adhesive composition for flip-chip-mounting a chip component such as an LED element on a circuit board.

Background Art

To improve the light extraction efficiency of a light-emitting diode (LED), the LED chip is flip-chip mounted on a substrate (Patent Document 1). This Patent Document discloses a method of mounting an LED chip on a substrate. More specifically, a substrate having a wiring pattern formed by selectively coating the surface of the substrate with a conductive paste is prepared. The surface having the wiring pattern formed thereon is coated in advance with an underfill resin composed of an insulating resin such as an epoxy resin. Then an LED chip is placed on the underfill resin with the bump-formed surface of the LED chip facing the wiring pattern of the substrate and is thermocompression-bonded to the substrate. In this case, the underfill resin plays a role in ensuring insulation between the positive and negative electrodes of the LED chip and securing the LED chip to the substrate.

An epoxy resin adhesive composition used as an underfill resin when an LED chip is flip-chip mounted on a substrate is required to be colorless and transparent after curing. Therefore, an alicyclic epoxy compound or a glycidyl hydrogenated bisphenol A compound, each of which has fast curability and does not have an unsaturated bond that can cause color development, is generally used as an epoxy component, and an alicyclic acid anhydride that can impart high transparency to a cured product and has high compatibility with the alicyclic epoxy compound is added as a curing agent. In addition, in terms of reducing the elastic modulus of a cured product to improve shock resistance and of preventing the resistance to discoloration of the cured product by heat and light from being reduced, attempts have been made to add, to an epoxy resin adhesive composition, an acrylic resin having a characteristic that adhesion properties are relatively high.

Citation List

Patent Literature

[Patent Literature 1] Japanese Patent Application Laid-Open No. Hei. 11-168235

Summary Of Invention

Technical Problem

However, even when an epoxy resin adhesive composition containing an acrylic resin is used to flip-chip mount an LED chip on a substrate, the problems including a reduction in adhesion, development of cloudiness in the cured product, development of color in the cured product, and corrosion of a trace formed on the substrate on which the chip has been mounted, may arise depending on the type of the acrylic resin. At present, no epoxy resin adhesive composition that can solve these problems simultaneously has not been proposed.

It is an object of the present invention to simultaneously solve the problems including "a reduction in adhesion," "development of cloudiness or color in a cured product," and "corrosion of a trace on a circuit board" that can occur when an acrylic resin is blended to an adhesive composition containing an alicyclic epoxy compound and an alicyclic acid anhydride and used to flip-chip-mount a chip component including an optical semiconductor chip such as an LED chip on a circuit board.

Solution to Problem

The present inventors have found that the above object can be achieved by utilizing an adhesive composition comprising an acrylic resin in addition to an alicyclic acid anhydride curing agent and an alicyclic epoxy compound having high transparency, high resistance to discoloration, and fast curability. In this adhesive composition, the ratio of the amounts used of the components is specified, and the acrylic resin used is a copolymerization product of glycidyl methacrylate and alkyl (meth)acrylate in a specific ratio and has a water absorption ratio of equal to or less than a predetermined value. Thus, the present invention has been completed. In the present description, the term "alkyl (meth)acrylate" means alkyl acrylate or alkyl methacrylate.

Accordingly, the present invention provides an adhesive composition used to flip-chip-mount a chip component on a circuit board, the adhesive composition including an alicyclic epoxy compound, an alicyclic acid anhydride curing agent, and an acrylic resin, wherein
the amount of the alicyclic acid anhydride curing agent is 80 to 120 parts by mass based on 100 parts by mass of the alicyclic epoxy compound, and the amount of the acrylic resin is 5 to 50 parts by mass based on 100 parts by mass of the total amount of the alicyclic epoxy compound, the alicyclic acid anhydride curing agent, and the acrylic resin, and the acrylic resin is a resin that is obtained by copolymerization of 100 parts by mass of alkyl (meth)acrylate and 2 to 100 parts by mass of glycidyl methacrylate and that has a water absorption rate of 1.2% or less.

The present invention also provides a connection structure in which a chip component is flip-chip-mounted on a circuit board using the above-described adhesive composition.

Advantageous Effects of Invention

The adhesive composition of the present invention includes an alicyclic epoxy compound, an alicyclic acid anhydride curing agent, and an acrylic resin in a specific ratio. In addition to this, the acrylic resin used is a polymerization product of glycidyl methacrylate and alkyl (meth)acrylate in a specific ratio and has a water absorption rate of a predetermined value or less. Therefore, the occurrence of problems such as a reduction in adhesion, development of cloudiness or color in a cured product, and corrosion of a trace on a circuit board can be significantly suppressed.

Description of Embodiments

The present invention is an adhesive composition for flip-chip-mounting a chip component on a circuit board. In terms of chemical composition, the adhesive composition contains an alicyclic epoxy compound, an alicyclic acid anhydride curing agent, and an acrylic resin. Examples of the circuit board include glass epoxy substrates, glass substrates, and flexible substrates. No particular limitation is imposed on the chip component. To take full advantage of the effects of the present invention, the chip component is an optical semiconductor element, particularly an LED element.

Preferred examples of the alicyclic epoxy compound contained in the adhesive composition of the present invention include an alicyclic epoxy compound having at least two epoxy groups in its molecule. Such an alicyclic epoxy compound may be in a liquid form or a solid form. Two or more alicyclic epoxy compounds may be used in combination. Specific examples of such an alicyclic epoxy compound include glycidyl hexahydrobisphenol A, 3,4-epoxycyclohexenylmethyl-3',4'-epoxycyclohexene carboxylate, and 1,3,5-tris(2,3-epoxypropyl)-1,3,5-triazine-2,4,6(1H,3H,5H)-trione. Of these, glycidyl hexahydrobisphenol A or 3,4-epoxycyclohexenylmethyl-3',4'-epoxycyclohexene carboxylate can be preferably used because a cured product can have an optical transparency suitable for, for example, mounting an LED element and they have fast curability.

In the present invention, in addition to the alicyclic epoxy compound, another epoxy compound may also be used, so long as the effects of the invention are not impaired. Examples thereof include known epoxy resins such as: glycidyl ethers obtained by reacting epichlorohydrin with a polyhydric phenol such as bisphenol A, bisphenol F, bisphenol S, tetramethyl bisphenol A, diallyl bisphenol A, hydroquinone, catechol, resorcin, cresol, tetrabromobisphenol A, trihydroxybiphenyl, benzophenone, bisresorcinol, bisphenol hexafluoroacetone, tetramethylbisphenol A, tetramethylbisphenol F, tris(hydroxyphenyl)methane, bixylenol, phenol-novolac, or cresol-novolac; polyglycidyl ethers obtained by reacting epichlorohydrin with an aliphatic polyhydric alcohol such as glycerin, neopentyl glycol, ethylene glycol, propylene glycol, butylene glycol, hexylene glycol, polyethylene glycol, or polypropylene glycol; glycidyl ether esters obtained by reacting epichlorohydrin with a hydroxycarboxylic acid such as p-oxybenzoic acid or β-oxynaphthoic acid; polyglycidyl esters obtained from polycarboxylic acids such as phthalic acid, methylphthalic acid, isophthalic acid, terephthalic acid, tetrahydrophthalic acid, endomethylene tetrahydrophthalic acid, endomethylene hexahydrophthalic acid, trimellitic acid, and polymerized fatty acid; glycidylaminoglycidyl ethers obtained from aminophenols and aminoalkylphenols; glycidylaminoglycidyl esters obtained from amino benzoic acids; glycidylamines obtained from aniline, toluidine, tribromoaniline, xylylenediamine, diamino cyclohexane, bisaminomethylcyclohexane, 4,4'-diaminodiphenylmethane, and 4,4'-diaminodiphenylsulfone; and epoxidized polyolefins.

Specific examples of the alicyclic acid anhydride curing agent include methylhexahydrophthalic anhydride and 2,4-diethyl-1,5-pentanedioic anhydride. Of these, methylhexahydrophthalic anhydride can be preferably used because it can provide a cured product having an optical transparency suitable for, for example, mounting an LED element and has good compatibility with the alicyclic epoxy compound.

The amounts used of the alicyclic epoxy compound and alicyclic acid anhydride curing agent in the adhesive composition of the invention will be described. When the amount of the alicyclic acid anhydride curing agent is too small, the adhesion tends to be low. When the amount is too large, corrosion resistance tends to be low. Therefore, the amount used of the alicyclic acid anhydride curing agent is preferably 80 to 120 parts by mass based on 100 parts by mass of the alicyclic epoxy compound and more preferably 90 to 110 parts by mass.

The adhesive composition of the present invention contains an acrylic resin for the purpose of reducing the elastic modulus of a cured product and improving shock resistance and other purposes. This acrylic resin is a resin obtained by copolymerization of 100 parts by mass of alkyl (meth)acrylate and 2 to 100, preferably 5 to 70, parts by mass of glycidyl methacrylate. Preferred examples of the alkyl (meth)acrylate include ethyl acrylate, butyl acrylate, and 2-ethyl acrylate.

The acrylic resin has a water absorption rate of 1.2% or less and preferably 1.0% or less. This is because when the water absorption rate exceeds 1.2%, the risk of corrosion of a metal-made electrode increases. The water absorption rate is determined according to JIS K7209. Specifically, an acrylic resin sheet having a thickness of 1.0 mm is cut into specimens of a width of 1 cm and a length of 1 cm. The obtained specimens are dried in a vacuum oven at 80°C for 20 hours, and the weight ($W_0$) of each specimen is measured. Then the specimen is left to stand in an environment of 85°C and 85%RH for 24 hours, and its weight ($W_1$) is measured. The water absorption rate is computed using the following equation.

$$\texttt{Water absorption rate (\%) = } \left\{ (W_1 - W_0)/W_0 \right\} \texttt{ x 100}$$

If the weight average molecular weight of the acrylic resin is too small, adhesion becomes low. If the weight average molecular weight is too large, the acrylic resin is not easily mixed with the alicyclic epoxy compound. Therefore, the weight average molecular weight of the acrylic resin is preferably 5,000 to 200,000 and more preferably 10,000 to 100,000. In addition, if the glass transition temperature of the acrylic resin is too high, adhesion becomes low. Therefore, the glass transition temperature is preferably 50°C or lower and more preferably 20°C or lower.

If the amount used of the acrylic resin is too small, adhesion tends to become low. If the amount is too large, optical properties tend to deteriorate. Therefore, the acrylic resin is used in an amount of preferably 5 to 50 parts by mass based on 100 parts by mass of the total amount of the alicyclic epoxy compound, alicyclic acid anhydride curing agent, and acrylic resin, and more preferably 10 to 40 parts by mass.

If necessary, an imidazole compound serving as a curing accelerator may be added to the adhesive composition of the present invention. Specific examples of the imidazole compound include 2-methyl-4-ethylimidazol. If the amount used of the imidazole compound is too small, curing becomes insufficient. If the amount used is too large, optical properties deteriorate. Therefore, the amount of the imidazole compound is preferably 0.01 to 10 parts by mass based on 100 parts by mass of the total amount of the alicyclic epoxy compound, alicyclic acid anhydride curing agent, and acrylic resin, and more preferably 0.1 to 5 parts by mass.

Preferably, for the purpose of improving heat resistance, and heat-and light-resistance, the adhesive composition of the present invention simultaneously contains a thermal antioxidant such as IRGANOX 1010 (Ciba Specialty Chemicals K.K.), a metal deactivator such as IRGANOX MD 1024 (Ciba Specialty Chemicals K.K.), and an ultraviolet absorbing agent such as Chimasorb 81 (Ciba Specialty Chemicals K.K.). Based on 100 parts by mass of the total amount of the alicyclic epoxy compound, alicyclic acid anhydride curing agent, and acrylic resin, the amount of the thermal antioxidant is preferably 0.01 to 10 parts by mass and more preferably 0.1 to 5 parts by mass, the amount of the metal deactivator is preferably 0.01 to 10 parts by mass and more preferably 0.1 to 5 parts by mass, and the amount of the ultraviolet absorbing agent is preferably 0.01 to 10 parts by mass and more preferably 0.1 to 5 parts by mass.

If necessary, various additives used also in conventional adhesive compositions may be added to the adhesive composition of the present invention. For example, a silane coupling agent and a filler may be added.

The adhesive composition of the present invention can be produced by uniformly mixing the alicyclic epoxy compound, the alicyclic acid anhydride curing agent, the acrylic resin, and, if necessary, other additives by a conventional method. The adhesive composition can be formed into any form such as a paste form, a film form, or a highly viscous liquid form by a conventional method. The adhesive composition is of the thermosetting type and can be cured by heating it to generally 150 to 250°C.

The adhesive composition of the present invention is used to flip-chip-mount a chip component such as an optical semiconductor chip, particularly an LED chip, on a circuit board. Therefore, in a connection structure obtained by flip-chip-mounting a chip component such as an optical semiconductor chip, particularly an LED chip, on a circuit board using the adhesive composition of the present invention, the occurrence of problems such as a reduction in adhesion, development of cloudiness or color in the cured product, and corrosion of a trace on the circuit board is significantly suppressed.

[Examples]

The present invention will next be described more specifically.

Reference Example 1 (Production of acrylic resin A) A four-necked flask equipped with a stirrer and a cooling tube was charged with 50 g of ethyl acrylate (EA), 50 g of butyl acrylate (BA), 10 g of glycidyl methacrylate (GMA), 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin A. The weight average molecular weight of the obtained acrylic resin A (EA 50 : BA 50 : GMA 10) was 80,000, and its glass transition temperature was -56°C. The water absorption rate was 1.0%.

Reference Example 2 (Production of acrylic resin B) A four-necked flask equipped with a stirrer and a cooling tube was charged with 70 g of butyl acrylate (BA), 30 g of glycidyl methacrylate (GMA), 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin B. The weight average molecular weight of the obtained acrylic resin B (BA 70 : GMA 30) was 110,000, and its glass transition temperature was -34°C. The water absorption rate was 0.5%.

Reference Example 3 (Production of acrylic resin C) A four-necked flask equipped with a stirrer and a cooling tube was charged with 70 g of 2-ethylhexyl acrylate (2-EHA), 30 g of glycidyl methacrylate (GMA), 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin C. The weight average molecular weight of the obtained acrylic resin C (2-EHA 70 : GMA 30) was 110,000, and its glass transition temperature was -33°C. The water absorption rate was 0.5%.

Reference Example 4 (Production of acrylic resin D) A four-necked flask equipped with a stirrer and a cooling tube was charged with 30 g of butyl acrylate (BA), 50 g of butyl methacrylate (BMA), 20 g of glycidyl methacrylate (GMA), 0.2 g of azobisbutyronitrile, 300 g of ethyl acetate, and 5 g of acetone. The mixture was subjected to a polymerization reaction at 70°C for 8 hours under stirring. The precipitated particles were collected by filtration, washed with ethanol, and dried to obtain acrylic resin D. The weight average molecular weight of the obtained acrylic resin D (BA 30 : BMA 50 : GMA 20) was 80,000, and its glass transition temperature was -4.2°C. The water absorption rate was 0.5%.

Reference Example 5 (Production of acrylic resin a) A four-necked flask equipped with a stirrer and a cooling tube was charged with 100 g of ethyl acrylate (EA), 10 g of acrylic acid, 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin a. The weight average molecular weight of the obtained acrylic resin a (EA 100 : Aac 10) was 95,000, and its glass transition temperature was -33°C. The water absorption rate was 1.5%.

Reference Example 6 (Production of acrylic resin b) A four-necked flask equipped with a stirrer and a cooling tube was charged with 70 g of methyl acrylate (MA), 30 g of glycidyl methacrylate (GMA), 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin b. The weight average molecular weight of the obtained acrylic resin b (MA 70 : GMA 30) was 110,000, and its glass transition temperature was 17°C. The water absorption rate was 1.7%.

Reference Example 7 (Production of acrylic resin c) A four-necked flask equipped with a stirrer and a cooling tube was charged with 70 g of ethyl acrylate, 30 g of glycidyl methacrylate (GMA), 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin c. The weight average molecular weight of the obtained acrylic resin c (EA 70 : GMA 30) was 100,000, and its glass transition temperature was -6°C. The water absorption rate was 1.5%.

Reference Example 8 (Production of acrylic resin d) A four-necked flask equipped with a stirrer and a cooling tube was charged with 70 g of ethyl acrylate (EA), 25 g of glycidyl methacrylate (GMA), 5 g of hydroxyethyl methacrylate, 0.2 g of azobisbutyronitrile, 300 g of ethyl acetate, and 5 g of acetone. The mixture was subjected to a polymerization reaction at 70°C for 8 hours under stirring. Precipitated particles were collected by filtration, washed with ethanol, and dried to obtain acrylic resin d. The weight average molecular weight of the obtained acrylic resin d (EA 70 : GMA 25 : HEMA 5) was 120,000, and its glass transition temperature was -5°C. The water absorption rate was 1.5%.

Examples 1 to 4 and Comparative Examples 1 to 8 Adhesive compositions were prepared by uniformly mixing components in blending ratios shown in Table 1 using a planetary mixer.

Evaluation tests The adhesion, optical properties (film appearance and color difference), and corrosion resistance of each of the paste-like adhesive compositions obtained in Examples 1 to 4 and Comparative Examples 1 to 8 were evaluated as described below.

<Adhesion test>

A glass epoxy circuit board having Cu traces flashplated with Au was coated with one of the paste-like adhesive compositions to a thickness of 25 $\mu$m. A 1.5-mm square IC chip was placed on the board and heated at 200°C for 60 seconds using a flip chip bonder to thermocompression-bond the IC chip, and a connection structure was thereby obtained. The adhesion strength (N/chip) of the IC chip in the connection structure was measured using a die shear tester (RTR-1100, RHESCA Co., Ltd.) immediately after the thermocompression-bonding (initial), after reflowing (260°C), and after the connection structure was left to stand at 150°C for 100 hours. The results obtained are shown in Table 1. The adhesion as measured under the conditions of the above adhesion test is practically preferably 5 N/chip or more.

<Optical property test>

The adhesive compositions were heated and pressed using a hot press to cure the compositions, and films having a thickness of 75 $\mu$m were thereby produced and used as specimens. The appearance of each of the obtained film specimens was observed visually. Then each specimen was caused to pass through a reflow furnace adapted to lead-free solder at a peak temperature of 260°C, and a color difference ($\Delta E^*ab$) was determined according to JIS K7105. Then a thermal aging test (the specimen was placed in an oven at 150°C for 300 hours) and a light aging test (30 W/m$^2$, light source with a peak wavelength of 380 nm, 60°C, 100 hours (fade meter, Suga Test Instruments Co., Ltd.)) were performed to determine the color difference ($\Delta E^*ab$) before and after the test. The results obtained are shown in Table 1.

<Corrosion resistance test>

The surface of a 2 cm-square glass epoxy substrate having Ag-plated traces obtained by plating copper trace pattern with Ag was coated with 0.05 g of one of the adhesive compositions, and the resultant substrate was placed in an oven at 150°C for 1 hour to cure the adhesive composition. Wiring lines were connected to wiring pads at the ends of the traces with lead-free solder. The resultant substrate was placed in a thermostatic and humidistatic chamber at 85°C and 85%RH. Then a voltage of 20 V was applied between electrodes for 50 hours. The Ag plated portions were observed visually, and the corrosion resistance of the adhesive composition was evaluated using the following evaluation criteria. The results obtained are shown in Table 1.

Criteria for corrosion resistance evaluation

> A: No change was found in the appearance of the Ag-plated traces
> B: Brown discoloration was found in the appearance of the Ag-plated traces
> C: Ag migration was found in the Ag-plated traces

[Table 1]

| | EXAMPLE | | | | COMPARATIVE EXAMPLE | | | | | | | |
|---|---|---|---|---|---|---|---|---|---|---|---|---|
| | 1 | 2 | 3 | 4 | 1 | 2 | 3 | 4 | 5 | 6 | 7 | 8 |
| Alicyclic Epoxy Compound [*1] | 55 | 55 | 55 | 55 | 55 | 55 | 55 | 55 | 55 | 55 | 55 | 100 |
| Acrylic Resin A[*2](EA50 : BA50 : GMA10) | 40 | | | | | | | | | | | |
| Acrylic Resin B[*3](BA70 : GMA30) | | 30 | | | | | | | | | | |
| Acrylic Resin C[*4](2-EHA70 : GMA30) | | | 30 | | | | | | | | | |
| Acrylic Resin D[*5](BA30 : BMA50: GMA20) | | | | 30 | | | | | | | | |
| Acrylic Resin a[*6](EA100 : Aac10) | | | | | 40 | | | | | | | |
| Acrylic Resin b[*7](MA70 : GMA30) | | | | | | | | | 30 | | | |
| Acrylic Resin c[*8](EA70 : GMA30) | | | | | | | | | | 30 | | |
| Acrylic Resin d[*9](EA70 : GMA 25 : HEMA 5) | | | | | | | | | | | 30 | |
| SEBS Rubber[*10] | | | | | | 40 | | | | | | |
| SIS Rubber[*11] | | | | | | | 40 | | | | | |
| Alicyclic Acid Anhydride Curing Agent[*12] | 45 | 45 | 45 | 45 | 45 | 45 | 45 | 45 | 45 | 45 | 45 | 45 |
| Curing Accelerator[*13] | 1 | 1 | 1 | 1 | 1 | 1 | 1 | 1 | 1 | 1 | 1 | 1 |
| Thermal AntioXidant[*14] | 0.5 | 0.5 | 0.5 | 0.5 | 0.5 | 0.5 | 0.5 | 0.5 | 0.5 | 0.5 | 0.5 | 0.5 |
| Metal Deactivator[*15] | 0.5 | 0.5 | 0.5 | 0.5 | 0.5 | 0.5 | 0.5 | 0.5 | 0.5 | 0.5 | 0.5 | 0.5 |
| Ultraviolet Absorbing Agent[*16] | 0.5 | 0.5 | 0.5 | 0.5 | 0.5 | 0.5 | 0.5 | 0.5 | 0.5 | 0.5 | 0.5 | 0.5 |

| | | EXAMPLE | | | | COMPARATIVE EXAMPLE | | | | | | | |
|---|---|---|---|---|---|---|---|---|---|---|---|---|---|
| | | 1 | 2 | 3 | 4 | 1 | 2 | 3 | 4 | 5 | 6 | 7 | 8 |
| Adhesion (Mpa) | Initial | 11 | 11 | 77 | 10 | 5 | 3 | 3 | 2 | 11 | 13 | 12 | 2 |
| | After Reflowing | 10 | 10 | 10 | 10 | 4 | 3 | 3 | 2 | 9 | 12 | 10 | 2 |
| | 150°C 100 h | 8 | 8 | 7 | 8 | 3 | 1 | 1 | 1 | 8 | 9 | 9 | 1 |
| Optical Properties | Film Appearance | Transparent | Transparent | Transparent | Transparent | Cloudy | Cloudy | Cloudy | Transparent | Transparent | Transparent | Transparent | Transparent |
| Color Difference ($\Delta$E*ab) | After Re-flowing | 0.2 | 0.2 | 0.3 | 0.1 | 0.8 | 2.7 | 3.1 | 0.2 | 0.2 | 0.4 | 0.3 | 0.2 |
| | 150°C 300 h | 1.1 | 1.1 | 1.1 | 0.8 | 1.5 | 6.7 | 10.2 | 1.1 | 1.3 | 1 | 1.1 | 0.9 |
| | After Fade Test | 0.4 | 0.4 | 0.3 | 0.5 | 2.5 | 3.4 | 4.2 | 0.5 | 0.3 | 0.3 | 0.3 | 0.1 |
| Corrosion Resistance | | A | A | A | A | C | B | B | B | B | B | B | A |

*1 Glyadyl Hexahydrobisphenol A(YX8000, JER Co., Ltd.)
*2 Reference Example 1 *10 TUFTEC H1030 (Asahi Kasei Corporation)
*3 Reference Example 2 *11 CT-130
*4 Reference Example 3 *12 Methyhexahydrophthalic Anhydride
*5 Reference Example 4 *13 2-Ethyl-4-Methylimidazole (Shikoku Chemicals Corporation)
*6 Reference Example 5 *14 IRGANOX 1010 (CIBA Specialty Chemicals K.K.)
*7 Reference Example 6 *15 IRGANOX MD 1024 (CIBA Specialty Chemicals K.K.)
*8 Reference Example 7 *16 Chimasorb 81 (CIBA Specialty Chemicals K.K.)
*9 Reference Example 8

EP 2 500 932 B1

As can be seen from Table 1, each of the adhesive compositions in Examples of 1 to 4 contains 81.2 parts by mass of an alicyclic acid anhydride curing agent based on 100 parts by mass of an alicyclic epoxy compound and 30 to 40 parts by mass of an acrylic resin based on 100 parts by mass of the total amount of the alicyclic epoxy compound and the alicyclic acid anhydride curing agent. Each acrylic resin is a copolymerization product of 100 parts by mass of glycidyl methacrylate and 230 to 1,000 parts by mass of alkyl acrylate and has a water absorption rate of 0.5% or less. Therefore, all the results for adhesion, optical properties, and corrosion resistance were good.

However, in the adhesive composition in Comparative Example 1, since the acrylic resin did not dissolve in the alicyclic epoxy compound, cloudiness occurred in the appearance of the film.

In the adhesive composition in Comparative Example 2, since SEBS rubber did not dissolve in the alicyclic epoxy compound, cloudiness occurred in the appearance of the film.

In the adhesive composition in Comparative Example 3, since SIS rubber did not dissolve in the alicyclic epoxy compound, cloudiness occurred in the appearance of the film.

In the adhesive composition in Comparative Example 4, since its cured product was hard and brittle, the adhesion strength was low.

In the adhesive composition in Comparative Example 5, since the water absorption rate of the acrylic resin was high, severe corrosion occurred in the Ag-plated traces.

In the adhesive composition in Comparative Example 6, since the acrylic resin contained a large number of glycidyl groups and the water absorption rate was high, severe corrosion occurred in the Ag-plated traces.

In the adhesive composition in Comparative Example 7, since the acrylic resin contained a large number of OH groups and the water absorption rate was high, severe corrosion occurred in the Ag-plated traces.

In the adhesive composition in Comparative Example 8, since the amount of the epoxy compound was large, part of the epoxy compound remained uncured, and the adhesive strength was low.

Industrial Applicability

The adhesive composition of the present invention includes an alicyclic epoxy compound, an alicyclic acid anhydride curing agent, and an acrylic resin in a specific ratio. The acrylic resin used is a polymerization product of glycidyl methacrylate and alkyl (meth)acrylate in a specific ratio and has a water absorption rate of equal to or less than a predetermined value. Therefore, the occurrence of problems such as a reduction in adhesion, development of cloudiness or color in a cured product, and corrosion of a trace on a circuit board can be significantly suppressed. The adhesive composition is useful when an optical semiconductor chip such as an LED chip is flip-chip-mounted on a circuit board.

**Claims**

1. An adhesive composition used to flip-chip-mount a chip component on a circuit board, the adhesive composition comprising an alicyclic epoxy compound, an alicyclic acid anhydride curing agent, and an acrylic resin, wherein an amount of the alicyclic acid anhydride curing agent is 80 to 120 parts by mass based on 100 parts by mass of the alicyclic epoxy compound, and an amount of the acrylic resin is 5 to 50 parts by mass based on 100 parts by mass of the total amount of the alicyclic epoxy compound, the alicyclic acid anhydride curing agent, and the acrylic resin, and
the acrylic resin is a resin that is obtained by copolymerization of 100 parts by mass of alkyl (meth)acrylate and 2 to 100 parts by mass of glycidyl methacrylate and that has a water absorption rate of 1.2% or less.

2. The adhesive composition according to claim 1, wherein the alicyclic epoxy compound is glycidyl hexahydrobisphenol A or 3,4-epoxycyclohexenylmethyl-3',4'-epoxycyclohexene carboxylate, and the alicyclic acid anhydride curing agent is methylhexahydrophthalic anhydride.

3. The adhesive composition according to claim 1 or 2, wherein the alkyl (meth)acrylate is ethyl acrylate, butyl acrylate, or 2-ethylhexyl acrylate.

4. The adhesive composition according to any of claims 1 to 3, comprising a thermal antioxidant in an amount of 0.01 to 10 parts by mass, a metal deactivator in an amount of 0.01 to 10 parts by mass, and a ultraviolet absorbing agent in an amount of 0.01 to 10 parts by mass, based on 100 parts by mass of the total amount of the alicyclic epoxy compound, the alicyclic acid anhydride curing agent, and the acrylic resin.

5. The adhesive composition according to any of claims 1 to 4, comprising 2-methyl-4-ethylimidazol as a curing accelerator in an amount of 0.01 to 10 parts by mass based on 100 parts by mass of the total amount of the alicyclic epoxy compound, the alicyclic acid anhydride curing agent, and the acrylic resin.

6. A connection structure in which a chip component is flip-chip-mounted on a circuit board using the adhesive composition according to any of claims 1 to 5.

7. The connection structure according to claim 6, wherein the chip component is an LED element.


**Patentansprüche**

1. Haftmittelzusammensetzung, verwendet zum Flip-Chip-Mount einer Chipkomponente auf einer Platine, wobei die Haftmittelzusammensetzung eine alicyclische Epoxyverbindung, ein Härtungsmittel eines alicyclischen Säureanhydrids und ein Acrylharz umfaßt, wobei eine Menge des Härtungsmittels eines alicyclischen Säureanhydrids 80 bis 120 Masse-Teile, bezogen auf 100 Masse-Teile der alicyclischen Epoxyverbindung, beträgt und eine Menge des Acrylharzes 5 bis 50 Masse-Teile bezogen auf 100 Masse-Teile der Gesamtmenge der alicyclischen Epoxyverbindung, des Härtungsmittels eines alicyclischen Säureanhydrids und des Acrylharzes beträgt, und
das Acrylharz ein Harz ist, welches durch Copolymerisation von 100 Masse-Teilen eines Alkyl(meth)acrylats und 2 bis 100 Masse-Teilen Glycidylmethacrylats erhalten worden ist und welches eine Wasserabsorptionsrate von 1,2% oder weniger aufweist.

2. Haftmittelzusammensetzung gemäß Anspruch 1, wobei die alicyclische Epoxyverbindung Glycidylhexahydrobisphenol A oder 3,4-Epoxycyclohexenylmethyl-3',4'-epoxycyclohexencarboxylat ist und das Härtungsmittel eines alicyclischen Säureanhydrids Methylhexahydrophthalsäureanhydrid ist.

3. Haftmittelzusammensetzung gemäß Anspruch 1 oder 2, wobei das Alkyl(meth)acrylat Ethylacrylat, Butylacrylat oder 2-Ethylhexylacrylat ist.

4. Haftmittelzusammensetzung gemäß einem der Ansprüche 1 bis 3, umfassend ein thermisches Antioxidans in einer Menge von 0,01 bis 10 Masse-Teile, einen Metalldeaktivator in einer Menge von 0,01 bis 10 Masse-Teile und ein UVabsorbierendes Mittel in einer Menge von 0,01 bis 10 Masse-Teile, bezogen auf 100 Masse-Teile der Gesamtmenge der alicyclischen Epoxyverbindung, des Härtungsmittels eines alicyclischen Säureanhydrids und des Acrylharzes.

5. Haftmittelzusammensetzung gemäß einem der Ansprüche 1 bis 4, umfassend 2-Methyl-4-ethylimidazol als ein Härtungsbeschleuniger in einer Menge von 0,01 bis 10 Masse-Teile, bezogen auf 100 Masse-Teile der Gesamtmenge der alicyclischen Epoxyverbindung, des Härtungsmittels eines alicyclischen Säureanhydrids und des Acrylharzes.

6. Verbindungsstruktur, in welcher eine Chip-Komponente unter Verwendung der Haftmittelzusammensetzung gemäß einem der Ansprüche 1 bis 5 auf einer Platine flip-chip-mounted worden ist.

7. Verbindungsstruktur gemäß Anspruch 6, wobei die Chip-Komponente ein LED-Element ist.


**Revendications**

1. Composition d'adhésif utilisée pour le montage à puce retournée d'un composant de puce sur une carte de circuit, la composition d'adhésif comprenant un composé d'époxy alicyclique, un agent de durcissement à base d'un anhydride d'acide alicyclique, et une résine acrylique, dans laquelle
une quantité de l'agent de durcissement à base d'un anhydride d'acide alicyclique est de 80 à 120 parties en masse sur la base de 100 parties en masse du composé d'époxy alicyclique, et une quantité de la résine acrylique est de 5 à 50 parties en masse sur la base de 100 parties en masse de la quantité totale du composé d'époxy alicyclique, de l'agent de durcissement à base d'un anhydride d'acide alicyclique et de la résine acrylique, et
la résine acrylique est une résine qui est obtenue par la copolymérisation de 100 parties en masse d'un (méth)acrylate d'alkyle et de 2 à 100 parties en masse de méthacrylate de glycidyle et qui présente un taux d'absorption d'eau inférieur ou égal à 1,2 %.

2. Composition d'adhésif selon la revendication 1, dans laquelle le composé d'époxy alicyclique est le glycidylhexahydrobisphénol A ou le carboxylate de 3,4-époxycyclohexènylméthyl-3',4'-époxycyclohexène, et l'agent de durcissement à base d'un anhydride d'acide alicyclique est l'anhydride méthylhexahydrophtalique.

3. Composition d'adhésif selon la revendication 1 ou 2, dans laquelle le (méth)acrylate d'alkyle est l'acrylate d'éthyle, l'acrylate de butyle ou l'acrylate de 2-éthylhexyle.

4. Composition d'adhésif selon l'une quelconque des revendications 1 à 3, comprenant un antioxydant thermique en une quantité de 0,01 à 10 parties en masse, un désactivateur de métal en une quantité de 0,01 à 10 parties en masse, et un agent absorbant les ultraviolets en une quantité de 0,01 à 10 parties en masse, sur la base de 100 parties en masse de la quantité totale du composé d'époxy alicyclique, de l'agent de durcissement à base d'un anhydride d'acide alicyclique et de la résine acrylique.

5. Composition d'adhésif selon l'une quelconque des revendications 1 à 4, comprenant du 2-méthyl-4-éthylimidazol en tant qu'accélérateur de durcissement en une quantité de 0,01 à 10 parties en masse sur la base de 100 parties en masse de la quantité totale du composé d'époxy alicyclique, de l'agent de durcissement à base d'un anhydride d'acide alicyclique et de la résine acrylique.

6. Structure de connexion dans laquelle un composant de puce est monté selon un montage à puce retournée sur une carte de circuit en utilisant la composition d'adhésif selon l'une quelconque des revendications 1 à 5.

7. Structure de connexion selon la revendication 6, dans laquelle le composant de puce est un élément de DEL.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI11168235 B